Europäisches Patentamt

European Patent Office

Office européen des brevets

(11) Publication number: **0 180 284**
A2

# (12) EUROPEAN PATENT APPLICATION

(21) Application number: **85201751.6**

(51) Int. Cl.⁴: **H 01 R 13/516**

(22) Date of filing: **28.10.85**

(30) Priority: **29.10.84 US 665954**

(43) Date of publication of application: **07.05.86**
**Bulletin 86/19**

(84) Designated Contracting States: **AT BE CH DE FR GB IT LI LU NL SE**

(71) Applicant: **E.I. DU PONT DE NEMOURS AND COMPANY, 1007 Market Street, Wilmington Delaware 19898 (US)**

(72) Inventor: **Nailor III, William Kirby, 2901 Merion Road, Camp Hill Pennsylvania 17011 (US)**
Inventor: **Sarricks, Jeffrey Dale, 17 Welty Avenue, Dillsburg Pennsylvania 17019 (US)**

(74) Representative: **van der Beek, George Frans et al, Nederlandsch Octrooibureau Johan de Wittlaan 15 P.O. Box 29720, NL-2502 LS 's-Gravenhage (NL)**

(54) **One-piece printed circuit board connector shell.**

(57) A one-piece metal shell (50, 150) for a printed circuit board connector.

## TITLE

## ONE-PIECE PRINTED CIRCUIT BOARD CONNECTOR SHELL

### Background of the Invention

This invention relates to electrical connectors for printed circuit boards ("PCBs"), and more particularly to metal shells for PCB connectors.

PCB connectors, such as the well-known "D-type" connector, typically include an array of metal terminals in a thermoplastic housing. The nose of the housing is typically provided with an outer metal shell structure which serves a variety of functions. The shell structure protects and reinforces the connector housing where the mating cable-terminating connector is attached. The shell tends to reduce electromagnetic emission from the connector during operation. The shell may also provide a ground connection for the shield of the cable connected to the connector. And the shell may provide attachment sites or structures for mechanically securing the connector to the PCB and/or for securing the mating cable-terminating connector to the PCB connector.

The known shell structures are made up of several pieces riveted or bolted together. These structures have a number of disadvantages. They are relatively costly, in part because of the need to assemble them from many separate parts. They may leak electromagnetic radiation between constituent parts. And they do not always lend themselves to robotic PCB assembly.

It is therefore an object of this invention to improve and simplify PCB connector shell structures.

## Summary of the Invention

This and other objects of the invention are accomplished in accordance with the principles of the invention by providing a one-piece PCB connector shell structure. The shell structure includes a hollow annular nose portion, a planar flange portion projecting radially outward from one open end of the nose portion, and a pair of laterally spaced PCB mounting tabs extending from the edge of the flange in the opposite direction from the nose portion, the mounting tabs being co-planar and substantially perpendicular to the plane of the flange. The shell is preferably made of (or converted to) spring steel, and particularly preferred embodiments include integral spring fingers for engaging the associated connector housing and thereby securing the shell to the housing. Preferred embodiments may also include integral PCB retaining latches extending down from the PCB mounting tabs through apertures in the PCB for engaging the underside of the PCB and thereby helping to hold the connector on the PCB. If desired, these latches may be soldered to the PCB ground circuit. Non-latching grounding tabs may be substituted for these latches. Integral stabilizers may extend beyond the PCB latches or grounding tabs. Apertures may be provided in the mounting tabs for additional means (e.g., bolts or rivets) for holding the connector to the PCB. Other apertures may be provided in the flange for jack screws or bolts for securing a cable-terminating connector to the PCB connector. Because the shell is preferably hardened spring steel, these jack screw apertures may be threaded and no additional reinforcement, such as a nut, is required to retain a jack screw in each aperture.

Further features of the invention, its nature and various advantages will be more apparent from the accompanying drawings and the following detailed description of the invention.

## Brief Description of the Drawings

Figure 1 is an exploded perspective view of a female PCB connector including the shell of this invention.

Figure 2 is an unexploded perspective view of the connector of Figure 1.

Figure 3 is a top plan view of the connector of Figure 2.

Figure 4 is a side elevational view of the connector of Figure 2.

Figures 5 and 6 are rear elevational views of the connector of Figure 2.

Figure 7 is a partial view similar to Figure 4 showing an alternative form of the connector terminals.

Figure 8 is a front elevational view of an alternative embodiment of the PCB connector shell of this invention.

Figure 9 is a side elevational view of the connector of Figure 8.

Figure 10 is a top plan view of the connector of Figure 8.

Figures 11-14 are partial perspective views of other alternative embodiments of the PCB connector shell of this invention.

## Detailed Description of the Invention

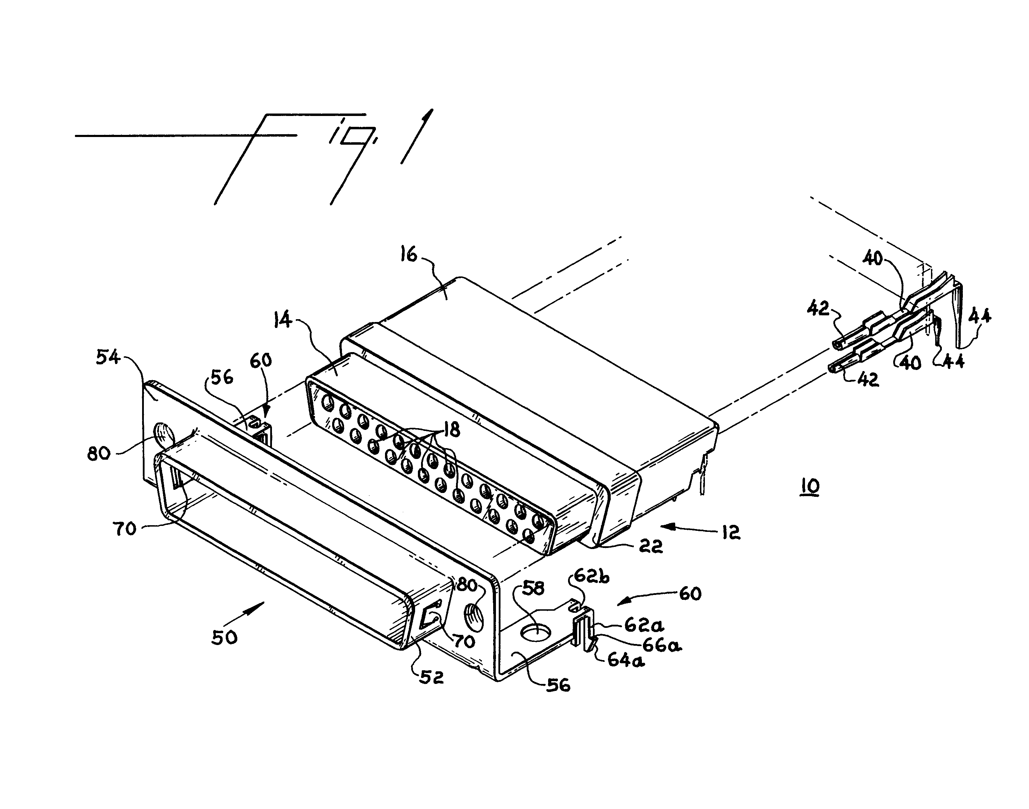

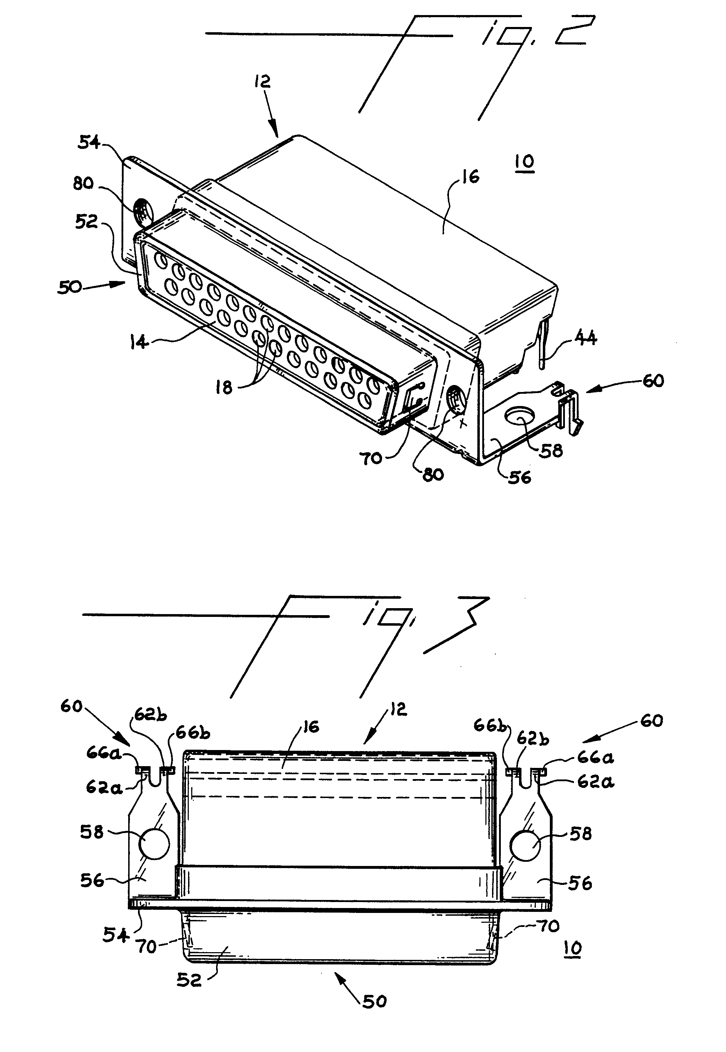

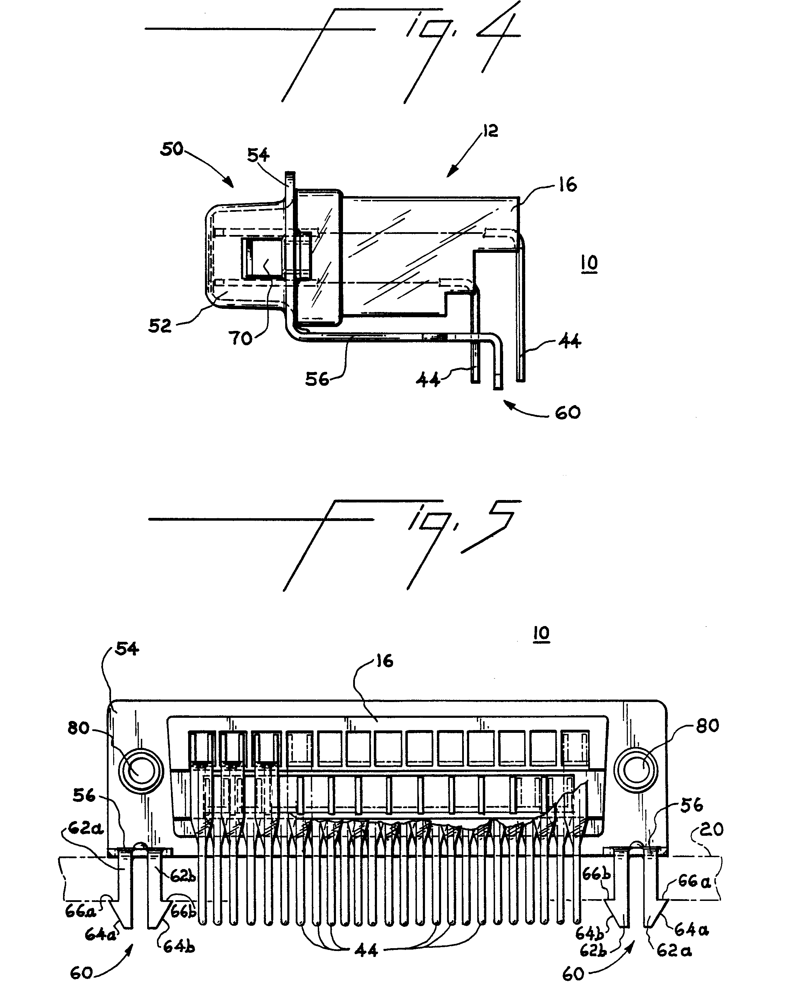

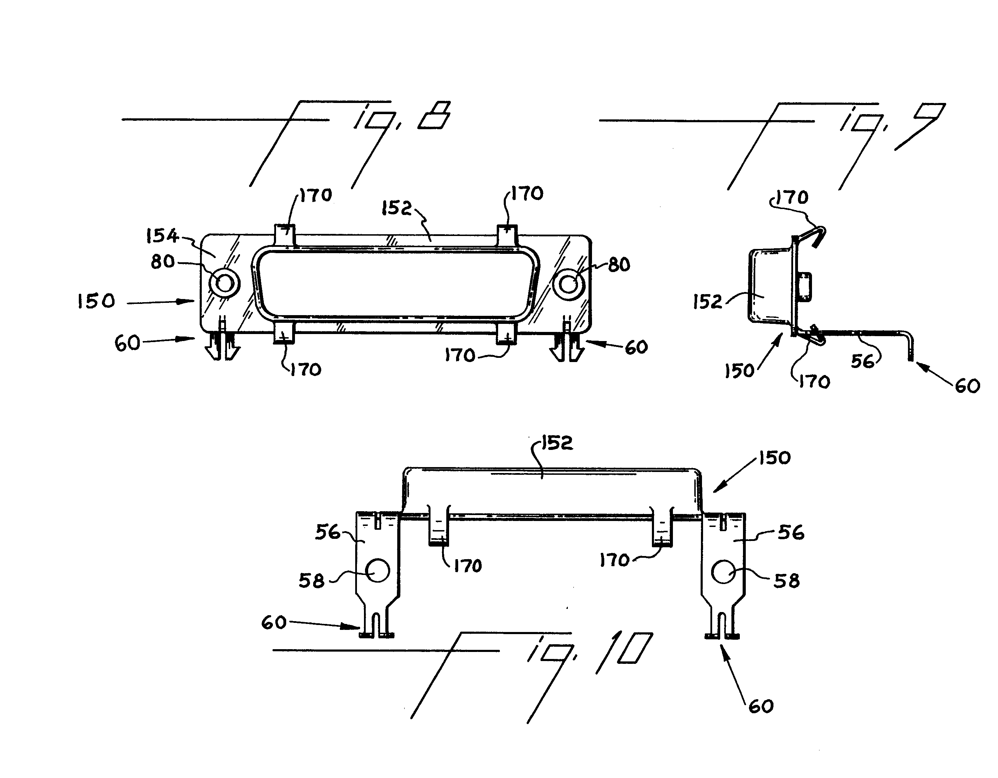

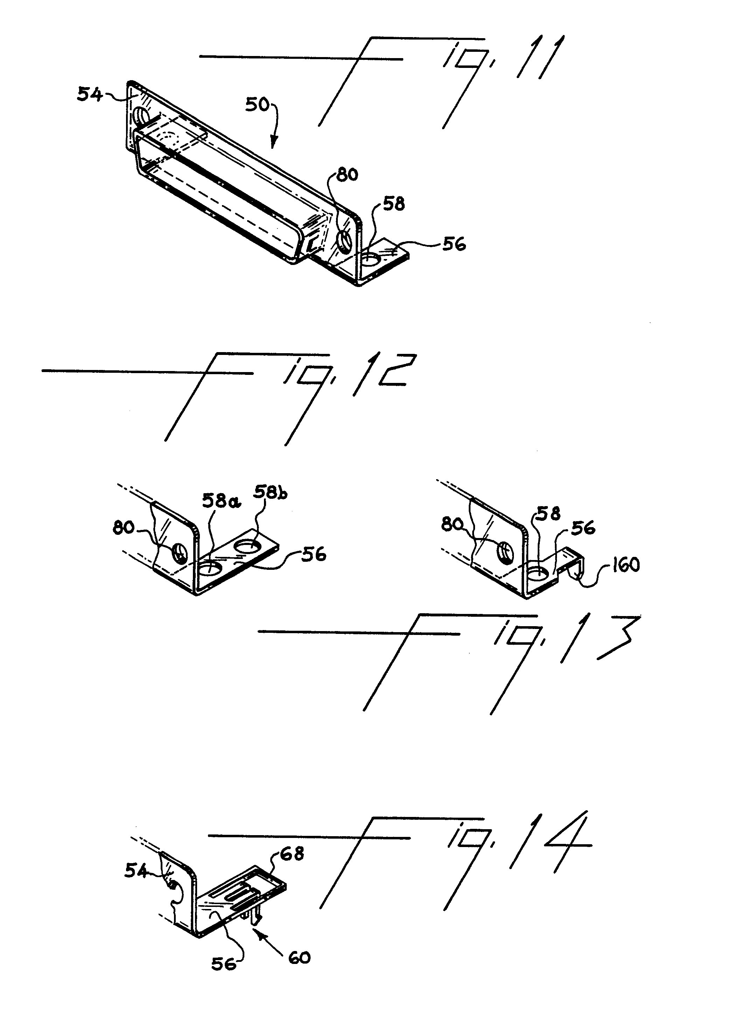

As shown in Figure 1 a typical female "D-type" PCB connector 10 includes thermoplastic contact housing 12 having a D-shaped nose portion 14 projecting outwardly from a somewhat larger main body portion 16. Housing 12 contains a plurality of metal terminals 40, each of which includes (1) a female contact area 42 located just inside an associated one of housing apertures 18 and (2) a solder tail 44 extending downwardly from the rear of the housing. In the particular embodiment shown in Figures 1-6, solder tails 44 are adapted to extend downwardly through apertures in PCB 20 so that they can be soldered to printed circuitry on the lower surface of the PCB. Alternatively, solder tails 44 can be configured as shown in Figure 7 for soldering to printed circuitry on the upper surface of PCB 20.

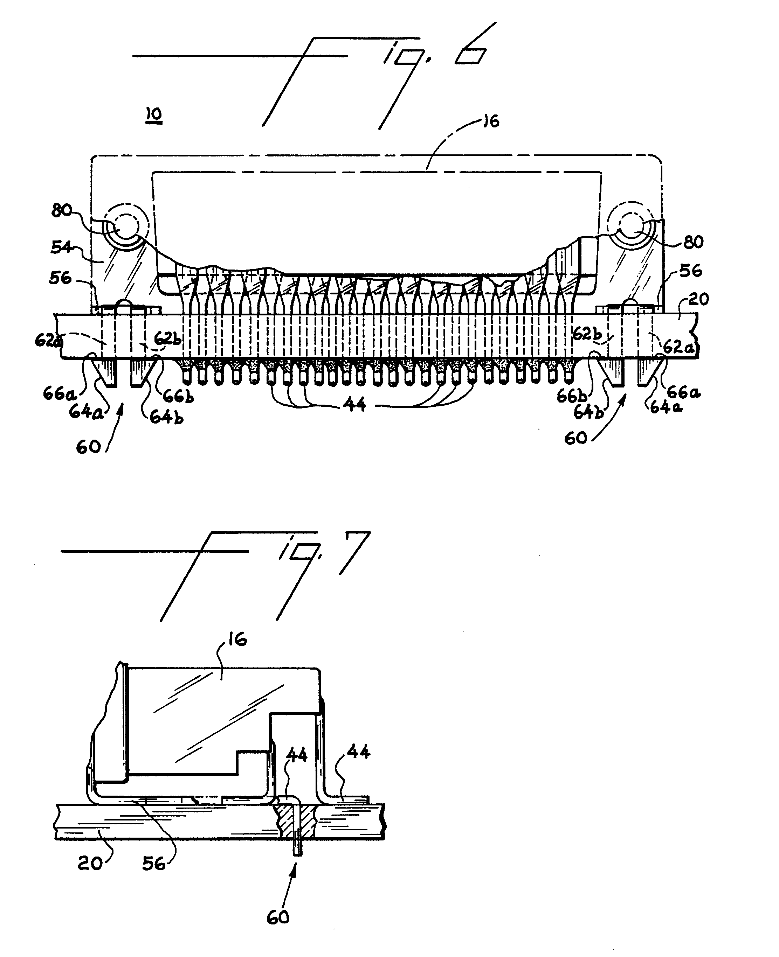

Reference number 50 denotes the one-piece PCB connector shell of this invention. Connector shell 50 includes annular nose portion 52 which fits around housing nose portion 14. A planar flange 54 extends radially outward from one open end of nose portion 52 in all directions. Flange 54 fits up against radially outwardly extending shoulder 22 at the base of housing nose portion 14. Adjacent each end of the edge of flange 54 is a rearwardly extending PCB mounting tab 56. Mounting tabs 56 are substantially co-planar and perpendicular to the plane of flange 54. As is best seen in Figures 4 and 5, the plane of tabs 56 is preferably below housing 12. Tabs 56 bear on the upper surface of PCB 20 and align connector 10 with the plane of the PCB. Apertures 58 may be provided in tabs 56 to facilitate securing connector 10 to PCB 20 by means of bolts, rivets, or the like.

The end of each mounting tab 56 remote from flange 54 is bent downwardly and forked to provide two parallel, laterally spaced tines 62a and 62b. Tines 62 terminate in synclinal ramp surfaces 64a and 64b, respectively. Behind ramp surfaces 64 are outwardly projecting shoulders 66a and 66b,

respectively. Elements 62, 64, and 66 constitute latches 60 for latching connector 10 to PCB 20. As shown in Figures 5 and 6, each pair of tines 62 extends down through a hole in PCB 20 so that shoulders 66 can engage the underside of the PCB. Synclinal ramp surfaces 64 facilitate insertion of tines 62 through the PCB hole. Tines 62 are typically deflected toward one another while ramp surfaces 64 are in contact with the side of the hole, and then tines 62 spring back to their initial spacing to force shoulders 66 outwardly under the lower surface of the PCB. If desired, tines 62 can be soldered to the ground circuit of PCB 20. For example, if there is a ground circuit on the lower surface of PCB 20, the lower ends of tines 62 can be soldered to that ground circuit.

Each side of nose portion 52 includes an inwardly projecting spring finger 70 for allowing housing nose portion 14 to be pushed into nose portion 52 from behind flange 54, and for thereafter engaging the sides of housing nose portion 14 to prevent separation of housing 12 and shell 50. Each spring finger 70 is integral with nose portion 52 along the end of the spring finger that is adjacent flange 54. The remainder of each spring finger is inclined inwardly of nose portion 52 in the direction away from flange 54. Accordingly, as housing nose portion 14 is pushed into nose portion 52, spring fingers 70 contact the sides of the housing nose portion but deflect away from one another to admit the housing nose portion into nose portion 52. Once housing nose portion 14 is in nose portion 52, however, the free ends of spring fingers 70 (i.e., the ends remote from flange 54), tend to dig into the sides of housing nose portion 14 to prevent

0180284

separation of housing 12 and shell 50. Thus spring fingers 70 constitute highly effective means for securing shell 50 to housing 12.

Adjacent each end of flange 54 an aperture 80 may be provided for insertion of jack screws or bolts (not shown) for the purpose of securing to connector 10 a male cable-terminating connector (also not shown) that is plugged into female PCB connector 10. If desired, apertures 80 may be internally threaded so that the jack screws can be threaded directly into apertures 80 with no need for a nut behind flange 54.

Shell 50 is preferably made of metal such as conventional 1035 cold rolled steel. Shell 50 is fully formed and then preferably heat treated (e.g., to Rockwell C35 hardness) to harden the steel and give it spring steel properties. This heat treating strengthens the resilience of tines 62 and spring fingers 70. It also hardens the threads provided in apertures 80 as described above. Shell 50 may be conventionally plated (e.g., with 93% tin, 7% lead) to make it solderable and better able to resist rust and/or corrosion.

Figures 8-10 show a shell 150 for use on a male "D-type" PCB connector. The thermoplastic housing (not shown) of the male connector does not have a nose portion like nose portion 14 in the female connector. Instead, it has an array of laterally spaced male contact pins that project into the area bounded by the nose portion 152 of shell 150. Because the male connector housing does not have a nose, shell nose 152 also does not include spring fingers like spring fingers 70 in the female connector shell. Instead, shell 150 has four latch fingers 170 extending rearwardly from the periphery of flange 154 for engaging rearwardly facing shoulders on the main body portion of the male contact housing. Like spring fingers 70 in the female connector, latch fingers 170 allow the male connector housing to be pushed into shell 150 from behind flange 154 and thereafter prevent the shell and housing from separating.

Except for the differences mentioned above, male connector shell 150 may be substantially similar to female connector shell 50. Accordingly, the same reference numbers are used throughout Figures 1-10 for features which are substantially identical throughout those Figures.

Figures 11-14 show several alternative shapes for PCB mounting tabs 56. In Figure 11, latches 60 are omitted from the mounting tabs. In Figure 12, latches 60 are again omitted, but mounting tabs 56 are extended to accommodate two holes 58a and 58b for use in securing the connector to the PCB. In Figure 13, latches 60 are replaced by solid grounding tabs 160 which project downwardly through the PCB for soldering to a ground circuit on the lower surface of the PCB. In Figure 14, in addition to latches 60, each mounting tab has a U-shaped stabilizer 68 which extends beyond the latch in the direction away from the shell flange. Stabilizers 68 increase the area of contact between the shell and the upper surface of the PCB and thereby increase the stability of the connector on the PCB. This may be beneficial in robotic assembly of PCBs. Stabilizers 68 can also be used with non-latching grounding tabs of the type shown in Figure 13.

8                    0180284

C L A I M S

1. A one-piece metal shell (50,150) for a printed circuit board connector comprising:

a hollow annular nose portion (52,152);

a flange portion (54, 154) extending radially outward from one open end of the nose portion;

at least one printed circuit board mounting tab (56) extending from the flange portion; and

means (76) for attaching the shell (50, 150) to the housing (12) of the printed circuit board connector.

2. The apparatus defined in claim 1 wherein the means for attaching the shell (50, 150) to the housing (12) comprises a plurality of spring fingers (70, 170) for engaging the connector housing.

3. The apparatus defined in claim 2 wherein the spring fingers (70, 170) allow the connector housing (12) to be pushed into the shell (50, 150) and subsequently prevent the connector (12) housing from being withdrawn from the shell (50, 150).

4. The apparatus defined in claim 3 wherein the connector housing (12) has a nose portion (14) which fits inside the nose portion (52) of the shell (50), and wherein the spring fingers (70) are formed in the nose portion of the shell and engage the nose portion of the connector housing.

5. The apparatus defined in claim 4 wherein the spring fingers (70) are inclined into the interior of the nose portion (52) of the shell (50) in the direction of insertion of the nose portion (14) of the housing into the shell (50).

6. The apparatus defined in claim 5 wherein the free ends of the spring fingers (70) bear on the sides of the nose portion of the housing.

7. The apparatus defined in claim 3 wherein the spring fingers (170) project from the flange (154) in the direction away from the nose portion and engage

0180284

shoulders on the connector housing which face away from the nose portion.

8. The apparatus defined in claim 1 wherein the flange (54, 154) extends annularly around the entire nose portion.

9. The apparatus defined in claim 1 wherein the flange includes a plurality of apertures (80) for receiving members for securing the printed circuit board connector to a mating connector.

10. The apparatus defined in claim 9 wherein the members for securing the printed circuit board connector to a mating connector are threaded jack screws and wherein the apertures (80) are threaded to threadedly engage the jack screws.

11. The apparatus defined in claim 1 wherein the mounting tab (56) is a planar member extending from the edge of the flange (54, 154) in the opposite direction from the nose portion (14) and substantially perpendicular to the flange (54, 154).

12. The apparatus defined in claim 11 wherein the mounting tab (56) is parallel to and bears on one surface of the printed circuit board.

13. The apparatus defined in claim 12 wherein the mounting tab (56) includes at least one aperture (58) for receiving a member for securing the shell to the printed circuit board.

14. The apparatus defined in claim 12 wherein the mounting tab (56) includes an extension (60, 160) which extends through the printed circuit board.

15. The apparatus defined in claim 14 wherein the extension (60) includes a latch (62, 64,66) for engaging the surface of the printed circuit board remote from said one surface to secure the connector to the printed circuit board.

16. The apparatus defined in claim 14 wherein the mounting tab (60, 160) includes a co-planar stabilizer member (68) extending beyond the extension in the direction away from the flange.

17. The apparatus defined in claim 1 wherein the shell is made of cold rolled steel, formed, and then heat treated to increase its hardness and spring characteristics.

Fig. 1

Fig. 2

Fig. 3

0180284

2/6

0180284

Fig. 4

Fig. 5

Fig. 6

Fig. 7

Fig. 7

Fig. 8

Fig. 10

Fig. 11

Fig. 12

Fig. 13

Fig. 14